# EUROPEAN PATENT APPLICATION

(11) **EP 2 073 252 A2**
(43) Date of publication of application: **24.06.2009**
(21) Application number: 08171670.6
(22) Date of filing: 15.12.2008
(51) Int. Cl.: H01L 21/00

(54) **Low cost high conductance chamber**

(30) Priority: 17.12.2007 US 958235
(71) Applicant: INTEVAC, INC., Santa Clara, California 95054 (US)
(72) Inventor: Samir, Tugrul, Sunnyvale, CA 94089 (US); Barnes, Michael S., San Ramon, CA 94583 (US); Bluck, Terry, Santa Clara, CA 95051 (US)
(74) Representative: Borchert, Uwe Rudolf

(57) **Abstract**

A process chamber having high conductance and a method of manufacturing the process chamber are disclosed. The process chamber is machined from a single piece of aluminum where a process cavity and a pump cavity are created by intersecting cylinders. A substrate opening is also created at a bottom of the process cavity to provide conduit for services, such as cooling gas and electrical connections. A large undercut area is formed at a top of the pump cavity between the pump cavity and the process cavity. The undercut extends past the process chamber centerline at the process cavity. A circular saw is used to remove material and create a plenum which extends beyond the process cavity centerline.

## Description

This invention generally relates to substrate processing chambers and more particularly to design and manufacture of substrate processing chambers that include vacuum pumping.

A variety of processes may be performed on a semiconductor substrate that include etch, chemical vapor deposition, physical vapor deposition, and other plasma or non-plasma processes. Many of these processes require a continuous exhaust of gases in the chamber to be replaced by new process gases. A relative vacuum is usually established and maintained in the chamber. Vacuum processing chambers are typically designed to meet performance specifications which include the degree of vacuum required within the chamber.

One problem typically encountered in conventional processing chambers is that the exhaust systems typically do not provide uniform and efficient pumping of the process gases from the processing chamber. In conventional processing chambers, the uniformity of process gas flow and the efficiency of process gas exhaust are limited by a variety of factors, such as the interior volume of the chamber, the placement of the chuck in the chamber, the size of the exhaust outlet, and the position of the exhaust outlet. These factors cause restrictions in the gas flow path, leading to pressure gradients within the process cavity. Thus, a vacuum processing chamber which reduces flow restrictions and achieves high and symmetrical flow is desirable.

One type of conventional processing chamber has a substantially cylindrical interior volume containing a fixed or movable substrate support member. Process gases are generally exhausted from the interior volume through a hole in the side of the processing chamber, or through a hole in the bottom of the chamber below a cantilevered substrate support member. The hole in the side is inherently partial to the side where it is located. With the hole in the bottom, the substrate support member often obstructs the flow of exhaust gases or otherwise results in non-uniform exhausting of the process chamber. This non-uniform exhausting of gases may lead to non-uniform processing results. The size of the exhaust outlet may limit conductance from the chamber to the exhaust system. Further, the abrupt transition between the exhaust outlet and the chamber wall disrupts smooth flow of the process gases to the exhaust outlet and hinders the exhaust process.

Therefore, there is a need for a processing chamber that provides efficient and uniform exhaust of processing gas from the chamber and may be manufactured at low cost.

The following summary of the invention is provided in order to provide a basic understanding of some aspects and features of the invention. This summary is not an extensive overview of the invention, and as such it is not intended to particularly identify key or critical elements of the invention, or to delineate the scope of the invention. Its sole purpose is to present some concepts of the invention in a simplified form as a prelude to the more detailed description that is presented below.

Aspects of the present invention provide a process chamber where an undercut is formed to enlarge a pumping area below the processing cavity to produce a chamber with high conductance, while maintaining the size of the processing cavity itself small.

Aspects of the present invention provide a process chamber that improves uniformity of gas flow to a vacuum pump.

Aspects of the present invention provide a process chamber where a pump opening, or cavity, and a process cavity are formed by intersecting cylindrical cuts from opposite sides in a same piece of metal. In one aspect of the invention, the metal is aluminum.

Aspects of the present invention provide a method of manufacturing a process chamber by using a circular saw on a milling machine to undercut a wall connecting a first cylindrical cavity, formed to include a substrate holder, to a second cylindrical cavity surrounding a pump.

Aspects of the present invention provide a process chamber and method of manufacturing a process chamber that requires a fewer number of pieces and seals compared to conventional methods.

According to aspects of the invention, a chamber is provided comprising: a chamber body comprising: a first cylindrical cut defining a process cavity; a second cylindrical cut defining a pumping cavity, the second cylindrical cut partially intersecting the first cylindrical cut to form fluid conduit therebetween; and an undercut connecting the first cylindrical cut to the second cylindrical cut and enlarging the fluid conduit. The chamber may have: a line segment connecting a center of a circular cross section of the first cylindrical cut to a center of a circular cross section of the second cylindrical cut along a same plane defines a chamber centerline, and the undercut extends past the chamber centerline at least at one of the process cavity end of the chamber centerline or the pumping cavity end of the chamber centerline. The chamber body may comprise a single piece of material. The material may be aluminum. The walls of the undercut may be parallel to cylindrical walls of the first cylindrical cut. The walls of the undercut may form an angle with cylindrical walls of the first cylindrical cut. A bottom portion of the first cylindrical cut may intersect a top portion of the second cylindrical cut. The first cylindrical cut may be open at one end of the chamber body; and the second cylindrical cut may be open at opposite end of the chamber body; the undercut may be connecting a partially closed end of the first cylindrical cut to a closed end of the second cylindrical cut; and a partial opening may be formed in the partially closed end of the first cylindrical cut.

According to aspects of the invention, a substrate processing system is provided, comprising: a chamber body formed in a single piece of material, the chamber body comprising: a first cylindrical cut defining a process cavity; a second cylindrical cut defining a pump cavity; and an undercut connecting the first cylindrical cut to the second cylindrical cut; a vacuum pump coupled to the pump cavity; a substrate holder situated within the process cavity; a gas source for providing processing gas to the process cavity; an RF power source connected to the process cavity; and a controller for controlling a flow of the processing gas to the process cavity and for controlling the RF power source. A line segment connecting a center of a circular cross section of the first cylindrical cut to a center of a circular cross section of the second cylindrical cut along a same plane may define a chamber centerline, and the undercut extends past the chamber centerline at least at one of the process cavity end of the chamber centerline or the pumping cavity end of the chamber centerline.

According to aspects of the invention, a method for manufacturing a processing system is provided, the method comprising: forming a first cylindrical cavity in a single piece of material from a first face thereof; forming a second cylindrical cavity in the single piece of material from a second face thereof, the second face being opposite to the first face; and forming an undercut passage between the first cylindrical cavity and the second cylindrical cavity. Forming the undercut passage may be performed by a circular saw. Forming an undercut passage may comprise forming the undercut passage such that at least at one of the first and second cylindrical cavities, the undercut passage extends past a chamber centerline, the chamber centerline being a line segment connecting a center of a circular cross section of the first cylindrical cavity to a center of a circular cross section of the second cylindrical cavity along a same plane. Forming an undercut passage may comprise forming the undercut passage such that the undercut passage is tangential to walls of the second cylindrical cavity. Forming an undercut passage may comprise forming the undercut passage such that at the second cylindrical cavity, the undercut passage extends past the chamber centerline, Forming an undercut passage may comprise forming the undercut passage such that the undercut passage is parallel to walls of the first cylindrical cavity and the second cylindrical cavity. Forming an undercut passage may comprise forming the undercut passage such that the undercut passage is at an angle with respect to walls of the first cylindrical cavity and the second cylindrical cavity. The method may further comprise: removing excess material from the single piece of material to conform to contours of the first cylindrical cavity and the second cylindrical cavity, and forming a partial opening in a partially closed end of the first cylindrical cavity. Forming a second cylindrical cavity may comprise forming a second cylindrical cavity substantially parallel to and partially intersect the first cylindrical cavity. The method may further comprise: coupling a processing gas source to the substrate processing chamber for providing processing gas to the first cylindrical cavity; coupling an RF power source to the substrate processing chamber for providing RF power to the first cylindrical cavity; coupling a controller to the processing gas source and the RF power source for controlling a flow of processing gas and the providing of RF power; coupling a vacuum pump to the second cylindrical cavity for forming a substantial vacuum in the substrate processing chamber; and connecting a substrate holder to the substrate processing chamber.

According to aspects of the invention, a chamber being formed from a single block of aluminum is provided, the chamber comprising: a chamber body including: a process cavity being cylindrical and having an opening in a top surface of the block; a pump cavity being cylindrical and having an opening in a bottom surface of the block, a bottom portion of the process cavity intersecting a top portion of the pump cavity in an intersection region; a substrate access hole being cylindrical and having an opening in the bottom surface of the block substantially coaxial with the process cavity; and an undercut region between the process cavity and the pump cavity and widening the intersection region, wherein walls of the undercut are tangential to walls of the pump cavity and extend beyond a chamber centerline at the process cavity, wherein the undercut extends vertically throughout a height of the intersection region.

According to aspects of the invention, a method of forming a chamber from a single block of aluminum is provided, the method comprising: milling a process cavity being cylindrical and having an opening in a top surface of the block; milling a pump cavity being cylindrical and having an opening in a bottom surface of the block, a bottom portion of the process cavity intersecting a top portion of the pump cavity in an intersection region; milling a substrate access hole being cylindrical and having an opening in the bottom surface of the block substantially coaxial with the process cavity; and cutting, using a circular saw, an undercut region between the process cavity and the pump cavity to thereby widen the intersection region.

The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.

Figures 1, 2, 3A and 3B show perspective views of a chamber during stages of manufacturing according to the aspects of the invention.

Figure 4 shows a method of manufacturing of a chamber according to the aspects of the invention.

Figure 5 shows the relationship between cavities of the chamber and an undercut in plan view according to one aspect of the invention.

Figure 6 shows the relationship between cavities of the chamber and an undercut in plan view according to one aspect of the invention.

Figure 7 shows the relationship between cavities of the chamber and an undercut in plan view according to one aspect of the invention.

Figure 8 shows the relationship between cavities of the chamber and an undercut in plan view according to one aspect of the invention.

Figure 9 shows a plasma processing system according to one aspect of the invention.

Figure 10 shows a vertical cross-sectional view of the plasma processing system of Figure 9 according to one aspect of the invention.

Figure 11 shows a plan view map of vacuum level at wafer level in a chamber according to the aspects of the invention in one exemplary simulation.

Figure 12 shows a vertical cross-sectional view of vacuum level in a chamber according to the aspects of the invention in one exemplary simulation.

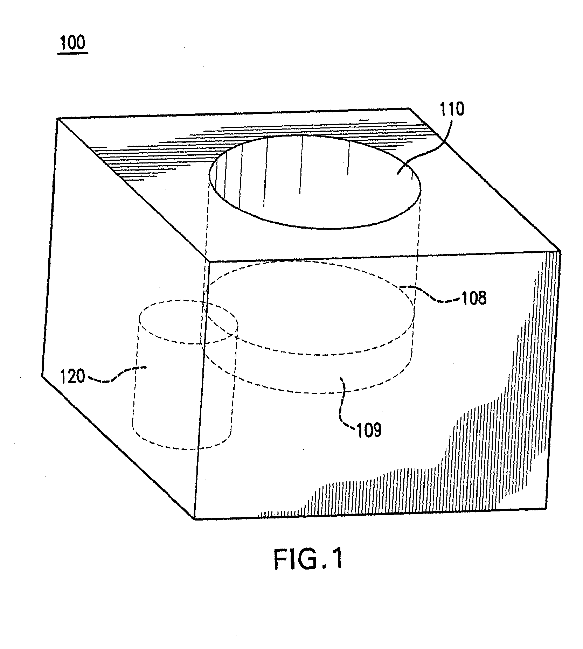

Figures 1, 2, 3A and 3B show perspective views of a chamber during stages of manufacturing or fabrication according to the aspects of the invention. A process chamber or a processing chamber used for processing substrates including semiconductor wafers may be referred to simply as a chamber.

Figure 1 shows a piece or a block of material 100. A process cavity 110 is formed in one part of the block 100. A pump cavity 120 is formed in another part of the block 100. The process cavity 110 and the pump cavity 120 are both cylindrical. The process cavity forms a cylinder or a cylindrical volume open to one surface of the block 100 and the pump cavity 120 forms another cylindrical volume open at an opposite surface of the block 100.

The piece of material 100 may be formed from a metal such as aluminum. The piece of material 100 may come in any prefabricated geometrical form. The piece of material 100 may be cubic.

When the piece of material 100 is cubic, the process cavity 110 and the pump cavity 120 may be formed such that their circular cross sections fall along a diagonal of one of the surfaces, The circular cross section of the process cavity 110 overlaps the circular cross section of the pump cavity 120.

in one aspect of the invention, the height of the cylinders or cylindrical volumes forming the process cavity 110 and the pump cavity 120 is such that the two cylindrical volumes intersect. In another aspect of the invention, the cylindrical volumes forming the process cavity 110 and the pump cavity 120 do not meet or intersect.

When the cylindrical volumes forming the process cavity 110 and the pump cavity 120 intersect, the process cavity 110 is effectively divided into a substantially completely cylindrical portion located above the intersection area and another portion located in the intersection area that is not cylindrical on one side due to the intersection with the pump cavity 120. The substantially completely cylindrical portion of the process cavity 110 is called the processing portion 108, and the portion below it is called pumping portion 109.

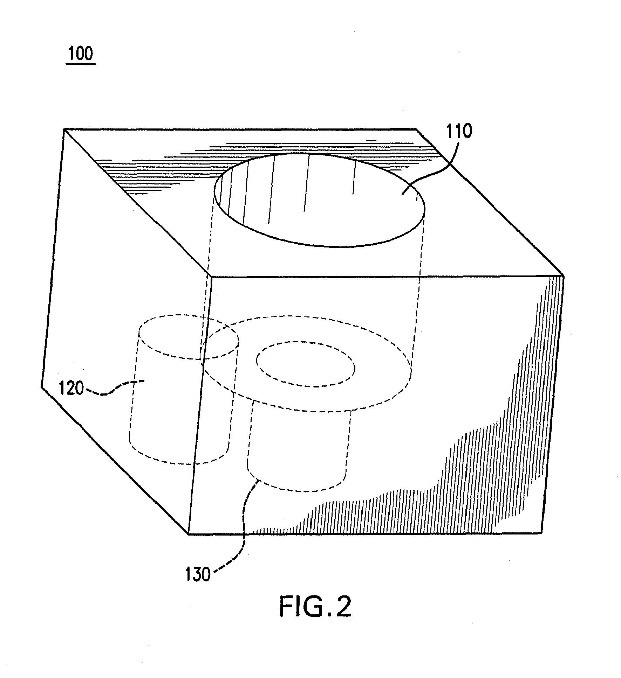

Figure 2 shows the piece of material 100 further including an access hole 130. The access hole 130 is cylindrical and concentric with the process cavity 110 and enables access of utilities, such electrical wires and gas pipes and hoses, and for lift pins actuators (not shown). The access hole 130 and the process cavity 110 are connected. In one aspect, the process cavity is open at one surface of the block 100 and the substrate access hole is open at an opposite surface of the block. The two surfaces may be top and bottom surfaces of the block 100.

In one aspect, the excess material above, below and around the process and pump cavities 110, 120 is removed to trim the block 100. Then, the access hole 130 may be formed after removing excess material from the block 100 in a region below the process cavity 110 by creating an opening in a lower surface of the process cavity 110.

The access hole 130 and the pump cavity 120 do not intersect. The diameter of the access hole 130 is smaller than the diameter of the process cavity 110.

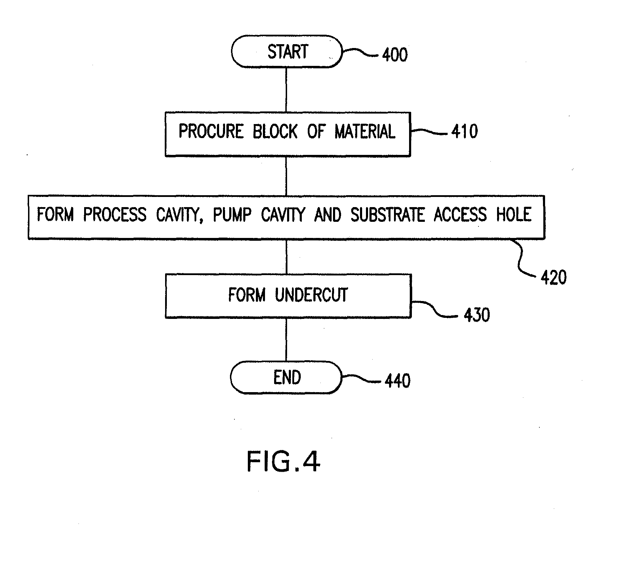

As the method of Figure 4 explains below, the process cavity 110, pump cavity 120 and access hole 130 may be formed consecutively or simultaneously.

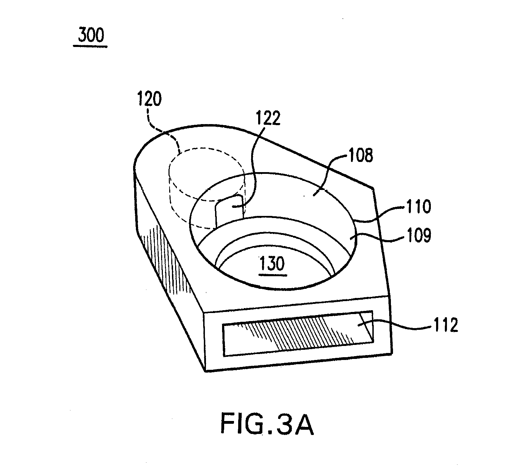

Figure 3A shows the piece of material 100 including the process cavity 110, the pump cavity 120 and the access hole 130. In Figure 3A, the piece of material 100 is cut around the periphery of the cavities to remove excess material and form a chamber 300. Figure 3A further shows an opening 112 for wafer transfer into and out of the processing cavity 110. A slot valve (not shown) is fitted to this opening for isolating the chamber during processing.

Before forming the undercut 140, the process cavity 110 and the pump cavity 120 may form two intersecting cylinders with each cylinder being open to an opposite surface, The processing portion 108 of the process cavity 110 is located above the intersection area of the two cylinders, while the pumping portion 109 is located at the level of opening 122. Since the two cavities intersect, they form an opening 122 there-between. However, this opening, while enabling fluid flow from the process cavity 110 to the pump cavity 120, provides very low conductance. Moreover, due to the size and location of the opening 122, an unacceptable pressure gradient forms in the process cavity 110. Embodiments of the invention alleviate these problems.

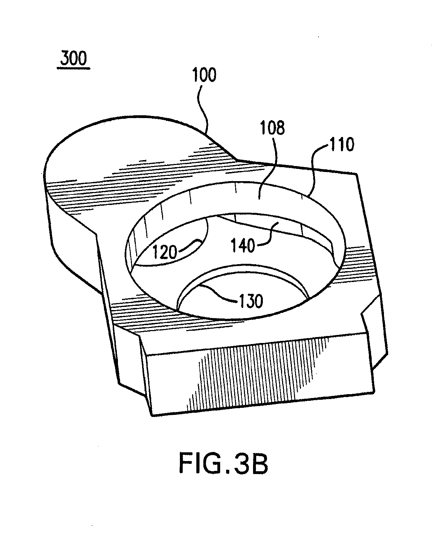

Figure 3B shows the chamber 300 after an undercut 140 is formed between the process cavity and the pump cavity 120. The undercut 140 enlarges a volume connecting the process cavity 110 and the pump cavity 120, beyond the original opening 122. After forming the undercut 140, the cylindrical shapes of a portion of both the process cavity 110 and the pump cavity 120 are modified by the undercut 140. Since the processing portion 108 of the process cavity 110 is located above the undercut 140, it is not modified by the undercut 140, thereby preserving its size and presenting a symmetrical chamber wall for substrate processing.

According to one aspect of the invention, the undercut 140 may be formed by a circular saw, which can be loaded onto a CNC machine. This is unlike the conventional methods, where the chamber is machined by expensive processes such as using an end mill on a CNC machine having complex tool path and programming. Rather, the undercut 140 may be easily and inexpensively formed using a circular saw mounted onto a CNC machine with very simple path.

In one aspect of the invention, two cylindrical cavities may be formed in one block of material and connected through a connecting passage. The cylindrical cavities may be non-intersecting. They may both have openings to a same side of the block. One of the cylindrical cavities serves as a process area and the other as an exhaust or a pump area. Excess material may be removed from an outer contour of the cylindrical cavities. A third opening, that may also be in the shape of a third cylindrical cavity, is formed to create a substrate opening or hole for services to a substrate carrier or chuck to enter the completely cylindrical cavity forming the processing portion. The connecting passage may be tangential to one or both of the cylindrical cavities. The connecting passage may include an undercut that is tangential to only one of the cylindrical cavities and extends past the centerline of a chamber formed by the two cavities at the other cavity. The connecting passage may be tangential to neither cavity and extend beyond the centerline on both sides. The centerline is a line segment connecting the center of one cavity to the center of the other cavity. The centerline is not continuous and ends at the center of each cavity.

Figure 4 shows a method of manufacturing of a chamber according to the aspects of the invention.

The method begins at 400. The method includes procuring a block of material 410. Then, a process cavity, a pump cavity and a substrate access hole are formed 420 in the block of material. Then, an undercut is formed 430 between the process cavity and the pump cavity to widen a passage connecting the process cavity and the pump cavity. The method may include removing excess material from outside of the cavities such that an outer contour of the chamber conforms to shapes of the cavities. The method then ends 440.

Formation 420 of the process cavity, the pump cavity and the substrate access hole may be done consecutively in any order or simultaneously. Further, the substrate access hole may be an opening formed by removing excess material from a closed end of the process cavity and forming an opening in the closed end of the process cavity.

In one aspect of the invention, the process cavity, the pump cavity and the substrate access hole are cut by machining or milling from within the block of material. In one aspect of the invention, formation 430 of the undercut is done by a circular saw.

The method of Figure 4, or a variation of this method, may be used for forming the chamber 300 of Figure 3B.

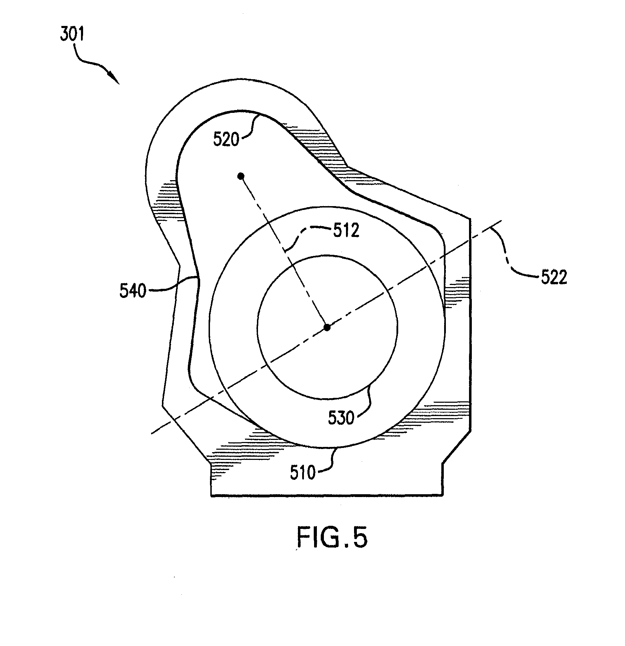

Figure 5 shows the relationship between the two cavities 110, 120 (see Figure 1) of a chamber 301 and an undercut 540 in plan view according to one aspect of the invention.

As shown in Figure 5, process cavity 510, pump cavity 520 and substrate access hole 530 all have circular cross sections in plan view. The process cavity 510 and the substrate access hole 530 have concentric circular cross sections. A centerline 512 connects centers of the process cavity 510 and the pump cavity 520. The centerline 512 may be called the chamber centerline 512. A line 522 is shown that is perpendicular to the centerline 512 and passes through the center of the process cavity. An undercut 540 provides fluid communication between the process cavity 510 and the pump cavity 520.

In the embodiment shown, the undercut 540 is tangential to the pump cavity 520 but not to the process cavity 510. The undercut 540 crosses the line 522 before turning around and reaching the perimeter of the process cavity 510. As such, the undercut 540 extends beyond the centerline 512 of the chamber 301. Therefore, where existing, the undercut 540 enlarges a portion of the process cavity 510 below the processing portion, where the substrate is to be located. The undercut 540 also enlarges a portion of the pump cavity 520 and a volume connecting the two cavities.

In one aspect of the invention, the undercut 540 includes walls that are parallel to cylindrical walls of the process cavity 510 and the pump cavity 520. In one aspect of the invention, an undercut is formed at an angle to the cylindrical walls of the process cavity 510 and the pump cavity 520. The undercut may have walls that widen to the top or to the bottom.

Aspects of the present invention provide a chamber that improves uniformity of gas flow to a pump by reducing sharp edges within the chamber that create turbulence in gas flow. Laminar gas flow is more efficient and more predictable. Turbulence is difficult to model and predict and causes friction which hinders fluid flow such as gas flow.

Aspects of the present invention preserve uniform plasma distribution around a substrate in a smaller chamber volume while enlarging a portion of the chamber that provides an exhaust path for gases within the chamber. As such, uniformity of substrate processing is preserved while enhancing exhaust of the gases from the chamber.

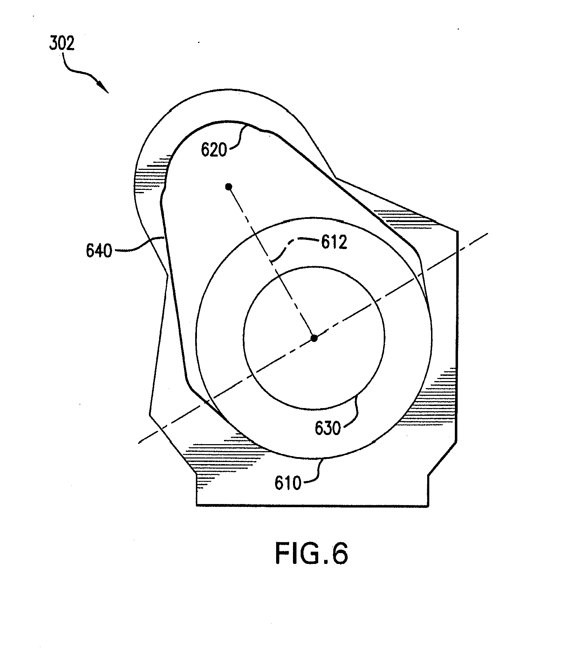

Figure 6 shows the relationship between cavities of a chamber 302 and an undercut 640 in plan view according to one aspect of the invention.

In Figure 6, an undercut 640 may be formed that is not tangential to either of a process cavity 610 or a pump cavity 620 and enlarges a formerly cylindrical shape of a portion of both cavities along a volume connecting the two cavities. In the embodiment of Figure 6, the undercut 640 extends beyond a chamber centerline 612 at both ends.

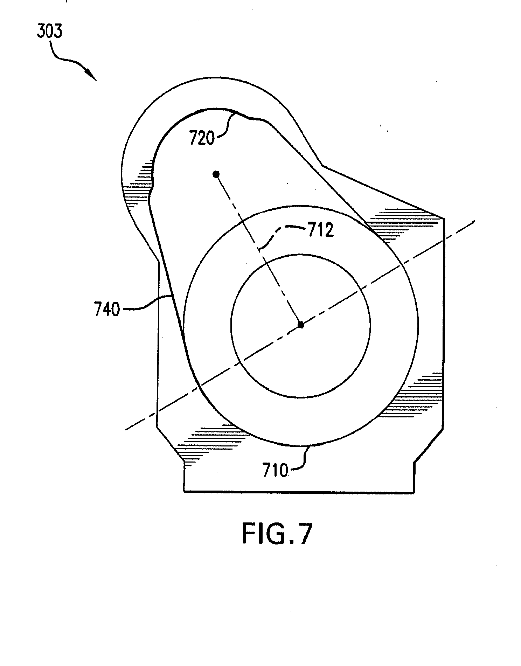

Figure 7 shows the relationship between cavities of a chamber 303 and an undercut 740 in plan view according to one aspect of the invention.

In Figure 7, an undercut 740 may be formed that is tangential to a process cavity 710 but not tangential to a pump cavity 720. The undercut 740, therefore, enlarges a formerly cylindrical shape of a portion of the pump cavity 720 along a volume connecting the two cavities. In the embodiment of Figure 7, the undercut 740 extends beyond a chamber centerline 712 at the pump cavity 720 end.

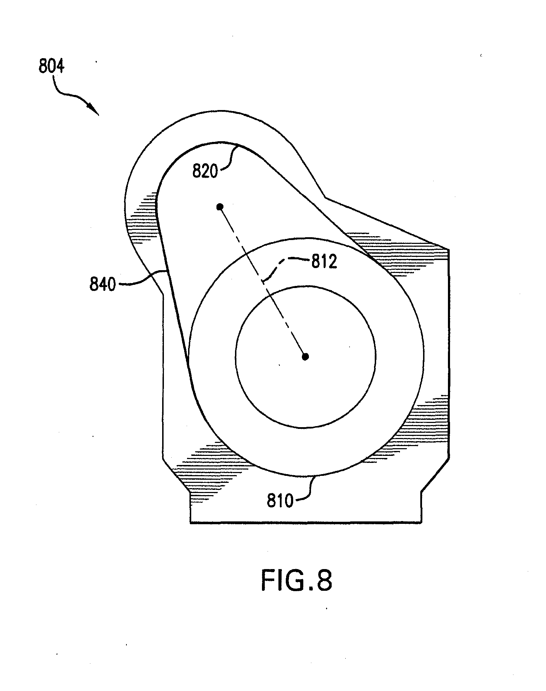

Figure 8 shows the relationship between cavities of a chamber 304 and an undercut 840 in plan view according to one aspect of the invention.

In Figure 8, an undercut 840 may be formed that is tangential to both a process cavity 810 and a pump cavity 820. The undercut 840, does not change the cylindrical shapes of the process cavity 810 or the pump cavity 820 beyond the two endpoints of the centerline 820 and does not extend beyond the chamber centerline 812 at either end.

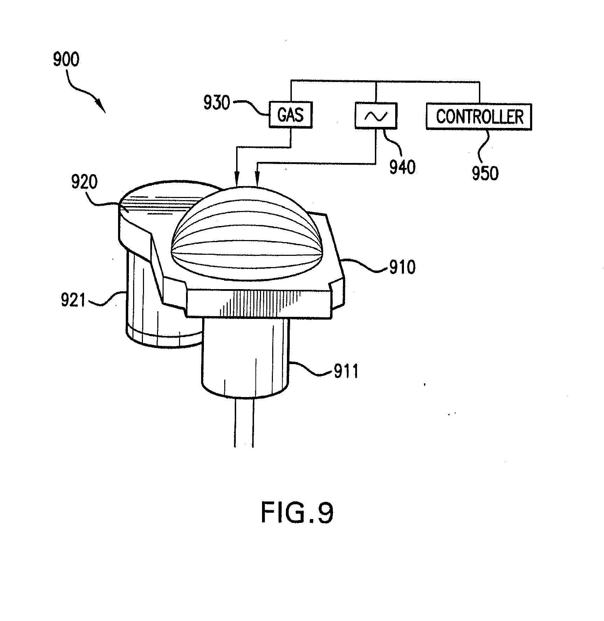

Figure 9 shows a plasma processing system according to one aspect of the invention.

The processing system of Figure 9 includes a chamber 900 that includes a process cavity 910 and a pump cavity 920. The processing system also includes a substrate holder 911 and a vacuum pump 921. The processing system further includes a gas source 930, an RF power source 940 and a controller 950.

The controller 950 is connected to the gas source 930 and the RF power source 940 and controls the flow of process gasses to the chamber 900. The substrate holder 911 may be stationary or movable. A movable substrate holder 911 lifts and lowers a substrate chuck into and out of a processing portion in a process cavity in the chamber 900. The vacuum pump 921 creates a vacuum in the chamber 900 by exhausting the gases inside the chamber via the undercut (not shown) through a pump cavity. While the chamber 900 is shown as having a dome-shaped lid, a flat lid or another shape of lid may be used in the process system of Figure 9.

The chamber 900 may be any one of the chambers described above according to different aspects of the invention and may be formed through any of the processes described above.

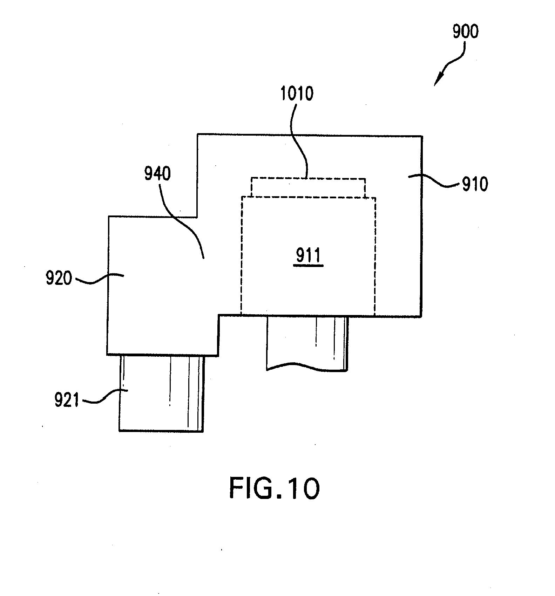

Figure 10 shows a vertical cross-sectional view of the plasma processing system of Figure 9 according to one aspect of the invention.

Figure 10 shows the intersection of the two cylindrical cavities 910, 920 where the undercut may be formed. Figure 10 also shows that a substrate 1010 is located over the substrate holder 911 such that it is surrounded by a substantially completely cylindrical portion of the process cavity 910 above the undercut area 940.

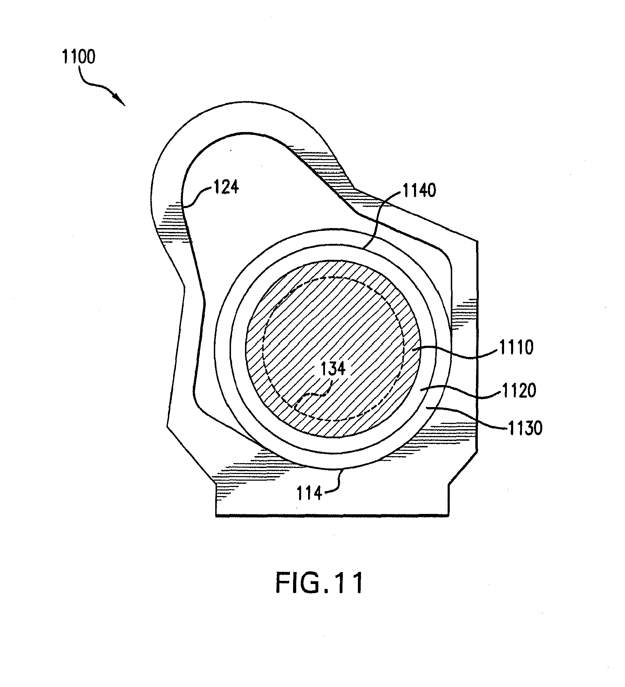

Figure 11 shows a plan view map of vacuum level at wafer level in a chamber according to the aspects of the invention in one exemplary simulation.

A chamber 1100 is shown where a vacuum is created in a process area 114 by a pump located in a pump area 124. A wafer 134 may be located in the process area 114. The vacuum created by the pump is strongest, meaning that it has the least gas pressure, at a region 1140 near the outer periphery of the process area 114 toward the pump area 124. The vacuum is also strong in the outer periphery of the process area that is shown as region 1130. Toward the center of the wafer 134, the vacuum pressure increases and the degree of vacuum is reduced. However, the vacuum level remains substantially constant over the wafer and beyond the perimeter of the wafer as shown by the extent of region 1110. Despite the sharp boundaries delineating the various hashed regions, the change in vacuum pressure is continuous and does not have sharp boundaries. In fact, the boundaries between the regions indicate a change in vacuum level that is a small percentage of the pressure at the center of each region.

In one exemplary aspect, a 2800 lps turbo pump is provided to create a vacuum in the chamber 1100. The process cavity diameter is about 21 inches and the pump cavity diameter is about 12 inches. Gas pressure at wafer level about 1mm above a pedestal holding a 12 inch wafer is measured. In this aspect of the invention, region 1110 is approximately at 1.120e-002, region 1120 is approximately at 1.096e-002, region 1130 is between 1.071e-002 and 1.047e-002 and region 1140 is at 1.022e-002. These values are expressed in pressure units of torr. As such, the boundaries between the regions indicate a change in vacuum level of less than 0.025e-002 torr. For example, in a region over the wafer 134 and beyond the perimeter of the wafer, vacuum pressured varies by less than the difference between 1.096e-002 and 1.120e-002 or by 0.024e-002 torr. This change in pressure is about only 2% of the pressure at the center of the region where the wafer is located.

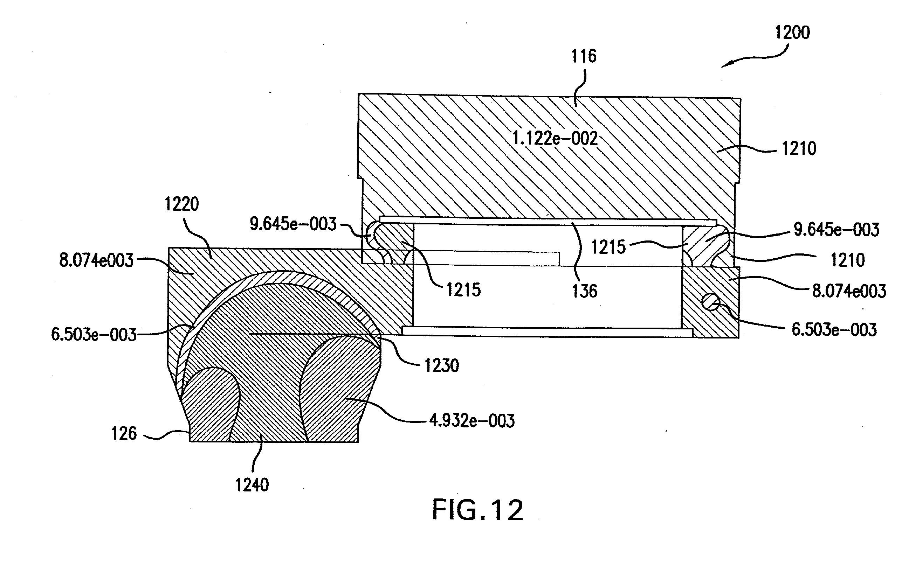

Figure 12 shows a vertical cross-sectional view of vacuum level in a chamber according to the aspects of the invention in one exemplary simulation.

A chamber 1200 is shown where a vacuum is created in a process area 116 by a pump located in a pump area 126. A wafer 136 may be located in the process area 116. The vacuum created by the pump is strongest, meaning that it has the least gas pressure, at a region 1240 in the pump area 126 near the pump. The vacuum is also strong near the top of the pump area that is shown as regions 1220 and 1230. Toward the process area 116, the vacuum pressure increases and the degree of vacuum is reduced. However, the vacuum level remains substantially constant over the wafer 136 and within the entire process area 116 as shown by the extent of region 1210. Below the wafer 136 in regions 1215, vacuum pressure is between the pressure inside the process area in region 1210 and pressure at the top of pump area in region 1220.

In one exemplary simulation a 2800lps turbo pump may be used in the pump area 126 to establish a vacuum in the chamber 1200. Then gas pressure in the region 1210 inside the process area 116 is about 1.122e-002 torr. Gas pressure in region 1215 is about 9.645e-003 torr, in region 1220 about 8.074e-003 torr, in region 1230 about 6.503e-003 torr and in region 1240 about 4.932e-003 torr. These values are approximate and gas pressure between adjacent regions changes gradually from one value to another value. However, these values indicate that a change in vacuum pressure between the highest level of vacuum near the pump in region 1240 and inside the process area 116 where the wafer 136 is located is less than 2%. Such a small change in pressure indicates uniformity of both vacuum and absence of turbulence or small levels of turbulence in gas flow,

In one aspect of the invention, a chamber is provided. The chamber includes a pump opening and a process cavity. The pump opening may also be called a pump cavity. The pump cavity opens from below and the process cavity opens from above. The pump opening and the process cavity are created by intersecting cylindrical cuts from opposite sides. The pumping plenum undercuts the top surface of the pump cavity between the process and pump openings. This undercut extends beyond chamber centerline. The chamber centerline is a line connecting a center of a cross section of the pump cavity to a center of a cross section of the process cavity. The undercut is designed to be fabricated with a circular saw on a milling machine to achieve low cost fabrication. The design of the cavities also allows for the use of a saw as opposed to expensive end mill operations.

A chamber, according to aspects of the invention, includes a fewer number of pieces and seals because the cavities are formed in a same piece of metal. Further, a higher pumping conductance with substantial pressure uniformity inside the process cavity may be obtained with the chamber according to aspects of the invention. Extending the undercut beyond the centerline helps create uniform pumping for process cavity away from pump opening. The undercut allows for a smaller process cavity while achieving uniform pumping performance of the larger tangential cavities.

Aspects of the present invention may provide a smaller chamber volume by including intersecting areas of processing and exhaust or pumping. Aspects of the present invention preserve uniform plasma distribution around a substrate in a smaller process chamber volume while enlarging a portion of the process chamber that provides an exhaust path for gases within the process chamber.

In one aspect of the invention, a method of manufacturing of a chamber is provided. According to this method, a chamber is machined from a single piece of aluminum. A process cavity and a pump opening, or cavity, are created by intersecting cylindrical cavities. A high pumping conductance and chamber pressure uniformity are achieved by large undercuts which extend past a chamber centerline. Top and bottom surfaces between the process and pump cavities are not separate pieces but are created by the machining of the cylindrical process and pump cavities. The opening between the process and pump cavities is enlarged by using a circular saw to remove material and create a plenum which extends beyond the chamber centerline. According to the method, the undercut is designed to be fabricated with a circular saw on a milling machine to achieve low cost fabrication.

Aspects of the present invention provide a method of manufacturing a chamber by using a circular saw on a milling machine to undercut a wall connecting a first cylindrical cavity, formed to include a substrate holder, to a second cylindrical cavity surrounding a pump.

The present invention has been described in relation to particular examples, which are intended in all respects to be illustrative rather than restrictive. Those skilled in the art will appreciate that many different combinations of hardware, software, and firmware will be suitable for practicing the present invention. Moreover, other implementations of the invention will be apparent to those skilled in the art from consideration of the specification and practice of the invention disclosed herein. It is intended that the specification and examples be considered as exemplary only, with a true scope of the invention being indicated by the following claims and their equivalents.

## Claims

1. A chamber comprising:
a chamber body comprising:
a first cylindrical cut defining a process cavity;
a second cylindrical cut defining a pumping cavity, the second cylindrical cut partially intersecting the first cylindrical cut to form fluid conduit therebetween; and
an undercut connecting the first cylindrical cut to the second cylindrical cut and enlarging the fluid conduit.

2. The chamber of claim 1, wherein:
a line segment connecting a center of a circular cross section of the first cylindrical cut to a center of a circular cross section of the second cylindrical cut along a same plane defines a chamber centerline, and
the undercut extends past the chamber centerline at least at one of the process cavity end of the chamber centerline or the pumping cavity end of the chamber centerline.

3. The chamber of claim 1, wherein a bottom portion of the first cylindrical cut intersects a top portion of the second cylindrical cut.

4. The chamber of claim 1, wherein:
the first cylindrical cut is open at one end of the chamber body;
the second cylindrical cut is open at opposite end of the chamber body;
the undercut is connecting a partially closed end of the first cylindrical cut to a closed end of the second cylindrical cut; and
a partial opening is formed in the partially closed end of the first cylindrical cut.

5. A substrate processing system comprising:
a chamber according to any of the claims 1-4 comprising:
a vacuum pump coupled to the pump cavity;
a substrate holder situated within the process cavity;
a gas source for providing processing gas to the process cavity;
an RF power source connected to the process cavity; and
a controller for controlling a flow of the processing gas to the process cavity and for controlling the RF power source.

6. A method for manufacturing a processing system, the method comprising:
forming a first cylindrical cavity in a single piece of material from a first face thereof;
forming a second cylindrical cavity in the single piece of material from a second face thereof, the second face being opposite to the first face; and
forming an undercut passage between the first cylindrical cavity and the second cylindrical cavity.

7. The method of claim 6, wherein forming the undercut passage is performed by a circular saw.

8. The method of claim 6,
wherein forming an undercut passage comprises forming the undercut passage such that at least at one of the first and second cylindrical cavities, the undercut passage extends past a chamber centerline, the chamber centerline being a line segment connecting a center of a circular cross section of the first cylindrical cavity to a center of a circular cross section of the second cylindrical cavity along a same plane.

9. The method of claim 8,
wherein forming an undercut passage comprises forming the undercut passage such that the undercut passage is tangential to walls of the second cylindrical cavity.

10. The method of claim 8,
wherein forming an undercut passage comprises forming the undercut passage such that at the second cylindrical cavity, the undercut passage extends past the chamber centerline.

11. The method of claim 6, further comprising:
removing excess material from the single piece of material to conform to contours of the first cylindrical cavity and the second cylindrical cavity, and
forming a partial opening in a partially closed end of the first cylindrical cavity.

12. The method of claim 6,
wherein forming a second cylindrical cavity comprises forming a second cylindrical cavity substantially parallel to and partially intersect the first cylindrical cavity.

13. The method of claim 6, further comprising:
coupling a processing gas source to the substrate processing chamber for providing processing gas to the first cylindrical cavity;
coupling an RF power source to the substrate processing chamber for providing RF power to the first cylindrical cavity;
coupling a controller to the processing gas source and the RF power source for controlling a flow of processing gas and the providing of RF power;
coupling a vacuum pump to the second cylindrical cavity for forming a substantial vacuum in the substrate processing chamber; and
connecting a substrate holder to the substrate processing chamber.

14. A chamber being formed from a single block of aluminum, the chamber comprising:
a chamber body including:
a process cavity being cylindrical and having an opening in a top surface of the block;
a pump cavity being cylindrical and having an opening in a bottom surface of the block, a bottom portion of the process cavity intersecting a top portion of the pump cavity in an intersection region;
a substrate access hole being cylindrical and having an opening in the bottom surface of the block substantially coaxial with the process cavity; and
an undercut region between the process cavity and the pump cavity and widening the intersection region,
wherein walls of the undercut are tangential to walls of the pump cavity and extend beyond a chamber centerline at the process cavity,
wherein the undercut extends vertically throughout a height of the intersection region.

15. A method of forming a chamber from a single block of aluminum, the method comprising:
milling a process cavity being cylindrical and having an opening in a top surface of the block;
milling a pump cavity being cylindrical and having an opening in a bottom surface of the block, a bottom portion of the process cavity intersecting a top portion of the pump cavity in an intersection region;
milling a substrate access hole being cylindrical and having an opening in the bottom surface of the block substantially coaxial with the process cavity; and
cutting, using a circular saw, an undercut region between the process cavity and the pump cavity to thereby widen the intersection region.
